# EUROPEAN PATENT APPLICATION

(11) **EP 4 030 179 A1**
(43) Date of publication of application: **20.07.2022**
(21) Application number: 21152221.4
(22) Date of filing: 19.01.2021
(51) Int. Cl.: G01R 33/565, G01R 33/3875, G01R 33/56, G01R 33/48

(54) **METHOD OF PREDICTING A FIELD PERTURBATION MAP FOR MAGNETIC RESONANCE IMAGING**

(71) Applicant: Koninklijke Philips N.V., 5656 AG Eindhoven (NL)
(72) Inventor: NEELAVALLI, Jaladhar, 5656 AE Eindhoven (NL); RUDRAPATNA, Umesh Suryanarayana, 5656 AE Eindhoven (NL); THAZHACKAL, Sharun S, 5656 AE Eindhoven (NL); M S, Vidya, 5656 AE Eindhoven (NL); SARASWATHY, Suja, 5656 AE Eindhoven (NL); SRINIVASAN, Ashvin, 5656 AE Eindhoven (NL)
(74) Representative: Philips Intellectual Property & Standards

(57) **Abstract**

Proposed concepts aim to provide schemes, solutions, concepts, designs, methods, systems, and a computer program pertaining to predicting a field perturbation map for magnetic resonance imaging (MRI) of a subject. In particular, the invention aims to provide a field perturbation map of the subject without the need for additional time-consuming scans of the subject. An accurate field perturbation map is necessary in order to obtain an MRI scan of the subject of high quality. Accordingly, a synthetic computed tomography (CT) image is generated by inputting an initial MRI magnitude image of the subject to an image conversion machine learning algorithm. Subsequently, a weighted susceptibility map of the subject is determined based on the synthetic CT image and the initial MRI magnitude image, which is in turn used to determine the field perturbation map of the subject.

## Description

### FIELD OF THE INVENTION

This invention relates to the field of magnetic resonance imaging (MRI), and particularly to obtaining field perturbation maps of a subject for MRI.

### BACKGROUND OF THE INVENTION

During an MRI scan, magnetic susceptibility variations within a subject lead to magnetic field inhomogeneities, which in turn lead to reduced image quality and integrity. As a result, it is typical to spend a significant amount of scanning time before the actual MRI scan in order to obtain field perturbation information, which may be used to compensate for these variations.

Instead of spending scanning time in order to obtain this field perturbation information, it is possible to predict the field perturbation map of a subject. However, field inhomogeneities are difficult to predict in vivo because susceptibility variations depend on subject anatomy. Additionally, the orientation of the subject also influences field inhomogeneities, and thus, subject motion will affect the field inhomogeneities. Moreover, the image distortions induced by the field inhomogeneities are also dependent on the scan settings. Thus, the magnitude of the observed imaging artifacts is dependent on all three independent variables, namely, subject anatomy, motion and the scan settings.

An additional problem arises if the subject moves between the field perturbation map acquisition and the actual MRI scan. This movement may cause a change in the field perturbation map, leading to degradation of image quality. For example, when a subject's head moves within the magnetic bore of the MRI scanner, the magnetic susceptibility field will also move. Hence, the field perturbation map changes and needs to be updated for the new head position.

There exist known methods of predicting field perturbation maps using analytic phase-based methods. These methods require the tissue geometry, type and corresponding magnetic susceptibility values to be used as inputs. Therefore, in order to perform field perturbation map prediction of a subject, the information about the subject's tissue geometry, structure and tissue type information needs to be obtained. Typically, current methods obtain this 'geometry and tissue-type' information from computed tomography (CT) images of the subject.

### SUMMARY OF THE INVENTION

The invention is defined by the claims.

According to examples in accordance with an aspect of the invention, there is provided a method of predicting a field perturbation map for magnetic resonance imaging (MRI) of a subject.

The method comprises: obtaining an initial MRI magnitude image of the subject; generating a synthetic computed tomography (CT) image based on the initial MRI magnitude image by using an image conversion machine learning algorithm; determining a weighted susceptibility map based on the synthetic CT image and the initial MRI magnitude image; and determining a field perturbation map for the subject based on the weighted susceptibility map.

Proposed concepts thus aim to provide schemes, solutions, concept, designs, methods and systems pertaining to predicting field perturbation maps for MRI. In particular, embodiments aim to reduce the time spent scanning a subject prior to an MRI scan, whilst also ensuring high image quality and integrity. This can achieved by predicting a field perturbation map of the subject, instead of spending additional scanning time mapping the magnetic field inhomogeneity caused by the subject. The prediction is based on information which is typically acquired during an MRI scan, therefore removing the need for additional scanning.

Specifically, the step of generating a synthetic CT image of the subject by using an image conversion machine learning algorithm based on an initial MRI magnitude image, means that performing a CT scan is not required in order to predict a field perturbation map. The synthetic CT image is then used alongside the initial MRI magnitude image to determine a weighted susceptibility map, and ultimately the field perturbation map of the subject. The initial MRI magnitude image is typically acquired during a survey scan of the subject, which is invariably performed during an MRI session. As a result, acquiring this information also does not add any additional time to the scanning process.

In other words, embodiments of the invention avoid the need to directly obtain the field perturbation map by scanning the subject, while also overcoming the time cost required to obtain geometry and tissue-type information of a subject necessary for predicting field perturbation map of the subject. By exploiting an image conversion machine learning algorithm, it is unnecessary to perform additional scanning of the subject to obtain the geometry and tissue-type information.

In some embodiments, the image conversion machine learning algorithm is trained using a training algorithm configured to receive an array of training inputs and known outputs. The training inputs comprise MRI images and the known outputs comprise CT images, with the MRI images and CT images being provided in pairs.

In some embodiments, determining the field perturbation map is further based on an analytical method.

In some embodiments, the method further comprises identifying susceptibility compartments of the subject based on the initial MRI magnitude image and the synthetic CT image. In this case, determining the weighted susceptibility map is based on the identified susceptibility compartments to account for a partial volume effect across boundaries.

In this way, the synthetic CT image and the initial MRI magnitude image may be used to accurately segment major susceptibility compartments of the subject, such as compartments in the head. Therefore, the weighted susceptibility map accounts for a partial volume effect across boundaries of tissues of the subject, ensuring a weighted susceptibility map of high quality. As a result, a more accurate field perturbation map may ultimately be obtained.

In some embodiments, the method further comprises regularizing the field perturbation map at interfaces based on a phase of the initial MRI magnitude image.

In some embodiments, the method further comprises correcting deficiencies of the field perturbation map by using an image regeneration machine learning algorithm.

In this way, known deficiencies of the field perturbation map may be corrected by a machine learning algorithm which can identify and correct deficiencies which may occur due to failure of the algorithm which converts the weighted susceptibility map into the field perturbation map.

In some embodiments, the method further comprises: determining movement of the subject; updating the weighted susceptibility map based on the movement of the subject; and updating the field perturbation map based on the updated weighted susceptibility map.

In other words, in some embodiments if it is detected that the subject has moved during the MRI scanning session, the weighted susceptibility map may be updated to reflect this. This improves the quality of the MRI images obtained, as the field perturbation map remains as accurate as possible, despite possible changes to field susceptibility.

In some embodiments, updating the weighted susceptibility map comprises updating the orientation of the weighted susceptibility map based on the movement of the subj ect.

According to examples in accordance with an aspect of the invention, there is provided a computer program comprising code means for implementing the method of any preceding claim when said program is run on a processing system.

According to another aspect of the invention, there is provided a system for predicting a field perturbation map for magnetic resonance imaging (MRI) of a subject.

The system comprises: an interface configured to obtain an initial MRI magnitude image of the subject; an image conversion component configured to generate a synthetic computed tomography (CT) image based on the initial MRI magnitude image by using an image conversion machine learning algorithm; a susceptibility mapping component configured to determine a weighted susceptibility map based on the synthetic CT image and the initial MRI magnitude image; and a perturbation mapping component configured to determine the field perturbation map of the subject based on the weighted susceptibility map.

In some embodiments, the image conversion component comprises a training unit configured to train the image conversion machine learning algorithm trained using a training algorithm configured to receive an array of training inputs and known outputs, wherein the training inputs comprise MRI images and the known outputs comprise CT images, and wherein the MRI images and CT images are provided in pairs.

In some embodiments, the perturbation mapping component comprises an analysis unit configured to determine the field perturbation map based on an analytical method.

In some embodiments, the susceptibility mapping component comprises a segmentation unit configured to identify susceptibility compartments of the subject based on the initial MRI magnitude image and the synthetic CT image. In this case, the susceptibility mapping component is further configured to determine the weighted susceptibility map based on the identified susceptibility compartments in order to account for a partial volume effect across boundaries.

In some embodiments, the perturbation mapping component further comprises an interface correction unit configured to regularize the field perturbation map at interfaces based on a phase of the initial MRI magnitude image.

In some embodiments, the perturbation mapping component further comprises a deficiency correction unit configured to correct deficiencies of the field perturbation map by using an image regeneration machine learning algorithm.

These and other aspects of the invention will be apparent from and elucidated with reference to the embodiment(s) described hereinafter.

### BRIEF DESCRIPTION OF THE DRAWINGS

For a better understanding of the invention, and to show more clearly how it may be carried into effect, reference will now be made, by way of example only, to the accompanying drawings, in which:
Fig. 1 is a flow diagram of an exemplary embodiment of a method for predicting a field perturbation map of a subject;
Fig. 2 is a flow diagram of a further exemplary embodiment of a method for predicting a field perturbation map of a subject, including motion detection, phase-based regularization, and deficiency correction;
Fig. 3 is a simplified block diagram of a system in which a predicted field perturbation map of a subject may be used prospectively; and
Fig. 4 is a simplified block diagram of an exemplary embodiment of a system for predicting a field perturbation map of a subject.

### DETAILED DESCRIPTION OF THE EMBODIMENTS

The invention will be described with reference to the Figures.

It should be understood that the detailed description and specific examples, while indicating exemplary embodiments of the apparatus, systems and methods, are intended for purposes of illustration only and are not intended to limit the scope of the invention. These and other features, aspects, and advantages of the apparatus, systems and methods of the present invention will become better understood from the following description, appended claims, and accompanying drawings. It should be understood that the Figures are merely schematic and are not drawn to scale. It should also be understood that the same reference numerals are used throughout the Figures to indicate the same or similar parts.

Variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality.

It should be understood that the Figures are merely schematic and are not drawn to scale. It should also be understood that the same reference numerals are used throughout the Figures to indicate the same or similar parts.

Implementations in accordance with the present disclosure relate to various techniques, methods, schemes and/or solutions pertaining to predicting a field perturbation map for magnetic resonance imaging, MRI, of a subject. According to proposed concepts, a number of possible solutions may be implemented separately or jointly. That is, although these possible solutions may be described below separately, two or more of these possible solutions may be implemented in one combination or another.

The disclosed invention obviates the need for a separate field perturbation map acquisition step when acquiring an MRI image of a subject, by predicting it using a combination of analytical physics-based methods and artificial intelligence (AI) algorithms.

Accordingly, the invention uses an image conversion machine learning algorithm which generates a synthetic CT image. In some embodiments, this may account for partial voluming across the tissue interfaces in order to obtain accurate geometry and tissue-type information. An analytic method is then used for predicting a personalized field perturbation map. The synthetic CT image is generated using a survey scan, which is always acquired during an MRI scan procedure for planning purposes.

Given physically accurate geometry and tissue-type information, analytical field perturbation map prediction methods still have inherent limitations in prediction-accuracy, especially at tissue interfaces. In some embodiments, these deviations may be learned using an image regeneration machine learning algorithm to improve prediction accuracy of the field perturbation map. In other embodiments, a phase component of the survey scan may be used for regularizing field perturbation map prediction.

Embodiments of the invention may yield the following key advantages over typical systems:
(a) Time saved by avoiding acquisition of multiple field perturbation maps in a scan session. The invention does not require acquisition of a field perturbation map. Hence the invention provides improved efficiency of the scans in terms of time.
(b) Image quality improvement by correcting for unaccounted motion during the scan. Field perturbation maps are not always acquired before every individual scan in an MRI session. Even if a field perturbation map is acquired, motion of the subject may occur after the pre-scan. This results in a mismatch between the field map and the actual field in the magnetic bore. All of these factors could lead to artifacts in the reconstructed image. Proposed embodiments overcome this challenge, as unaccounted subject motions are captured via the prediction of changes in the field perturbation map.
(c) Personalized field perturbation mapping is provided. Some embodiments utilize a survey scan, which is always acquired during a session, to extract necessary information for personalized field perturbation map prediction.

Further, the invention may comprise the following main elements:
(i) AI for generating synthetic CT image from an initial MRI magnitude image, for field perturbation map prediction.
(ii) Using phase data of the initial MRI magnitude image for regularizing the field perturbation map prediction.
(iii) Improved analytical prediction by identifying different regions of interest of the subject, and optimizing susceptibility assignment across those regions of interest.
(iv) Optimized geometry and tissue-type, and therefore susceptibility map, information extraction from synthetic CT image for improved field perturbation map prediction at tissue-interfaces.
(v) Correcting for known deficiencies in analytic field perturbation map prediction using AI. This results in improved accuracy in the predicted field perturbation map.

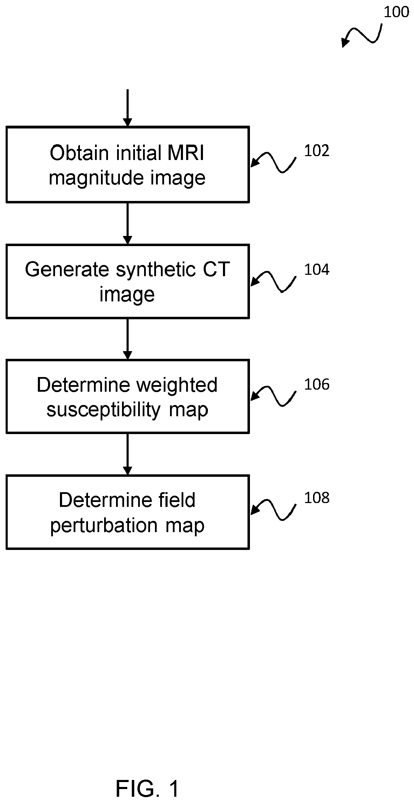

Referring now to Fig. 1, there is depicted a flow diagram of an exemplary embodiment of a method 100 for predicting a field perturbation map for MRI of a subject.

In step 102, an initial MRI magnitude image of the subject is obtained. This may be obtained during a survey scan, which are invariably performed prior to the main scanning session during an MRI scan of a subject. Alternatively, this may be obtained during the main scanning session, and be the first scan, the second scan, or any other MRI scan acquired.

In step 104, a synthetic CT image based on the initial MRI magnitude image is generated. This is generated by inputting the initial MRI magnitude image into the image conversion machine learning algorithm. The synthetic CT image may be approximately the same as a CT image acquired by directly performing a CT scan of the subject. As a result of step 104, it is not necessary to obtain a CT image of the subject in order to determine a weighted susceptibility map, and ultimately predict a field perturbation map. Accordingly, overall scanning time may be reduced.

The image conversion machine learning algorithm may be trained using a training algorithm configured to receive an array of training inputs and known outputs. The training inputs may comprise MRI images, and the known outputs may comprise CT images. The MRI images and CT images may be known MRI-CT image pairs.

As a result, by inputting the initial MRI magnitude of the subject into the trained image conversion machine learning algorithm, a synthetic CT image of the subject may be obtained.

The image conversion machine learning algorithm may be an artificial neural network (or, simply, a neural network). The structure of an artificial neural network is inspired by the human brain. Neural networks are comprised of layers, each layer comprising a plurality of neurons. Each neuron comprises a mathematical operation. In particular, each neuron may comprise a different weighted combination of a single type of transformation (e.g. the same type of transformation, sigmoid etc. but with different weightings). In the process of processing input data, the mathematical operation of each neuron is performed on the input data to produce a numerical output, and the outputs of each layer in the neural network are fed into the next layer sequentially. The final layer provides the output.

There are several types of neural network, such as convolutional neural networks (CNNs) and recurrent neural networks (RNNs). Embodiments of the present invention employ CNN-based learning algorithms, as CNNs have proved to be particularly successful at analyzing images, and are able to classify images with a much lower error rate than other types of neural network.

CNNs typically contain several layers, including a convolutional layer, a pooling layer, a fully connected layer and a softmax layer. The convolutional layer consists of a set of learnable filters and extracts features from the input. The pooling layer is a form of non-linear down-sampling, reducing the data size by combining the outputs of a plurality of neurons in one layer into a single neuron in the next layer. The fully connected layer connects each neuron in one layer to all the neurons in the next layer. The softmax layer determines a probability distribution for each output.

Methods of training a machine-learning algorithm are well known. Typically, such methods comprise obtaining a training dataset, comprising training input data entries and corresponding training output data entries. An initialized machine-learning algorithm is applied to each input data entry to generate predicted output data entries. An error between the predicted output data entries and corresponding training output data entries is used to modify the machine-learning algorithm. This process can be repeated until the error converges, and the predicted output data entries are sufficiently similar (e.g. ±1%) to the training output data entries. This is commonly known as a supervised learning technique.

For example, weightings of the mathematical operation of each neuron may be modified until the error converges. Known methods of modifying a neural network include gradient descent, backpropagation algorithms and so on.

The training input data entries for the plurality of CNN-based learning algorithms used in step 104 may correspond to MRI images of subjects. The training output data entries correspond to CT images of corresponding subjects. Accordingly, the MRI images and CT images may be known MRI-CT image pairs.

The plurality of CNN-based learning algorithms may be produced by modifying existing CNN-based learning algorithms, such as VGG, Inception and ResNet.

In step 106, a weighted susceptibility map of the subject is determined. This determination is based on the synthetic CT image and the initial MRI magnitude image. This step may be performed by a known analytic method.

In an exemplary embodiment, regions of interest may be segmented into compartments based on the initial MRI image, and the synthetic CT image. For example, the subject's head may be segmented into susceptibility compartments. The weighted susceptibility map may then be determined based on the identified susceptibility compartments. This method of determining the weighted susceptibility map accounts for a partial volume effect across boundaries. The partial volume effect can be defined as the loss of apparent activity in small objects or regions because of the limited resolution of the imaging system.

In step 108, a field perturbation map for the subject is determined based on the weighted susceptibility map. The field perturbation map may be obtained from the weighted susceptibility map by a known analytical method.

The field perturbation map may be used to set appropriate shim currents of the MRI machine, which reduce or eliminate magnetic field inhomogeneities. Alternatively, or in addition, the field perturbation map may be used to reconstruct the MRI images. In this way, artifacts in the MRI image of the subject may be suppressed, and an image of higher quality may be obtained.

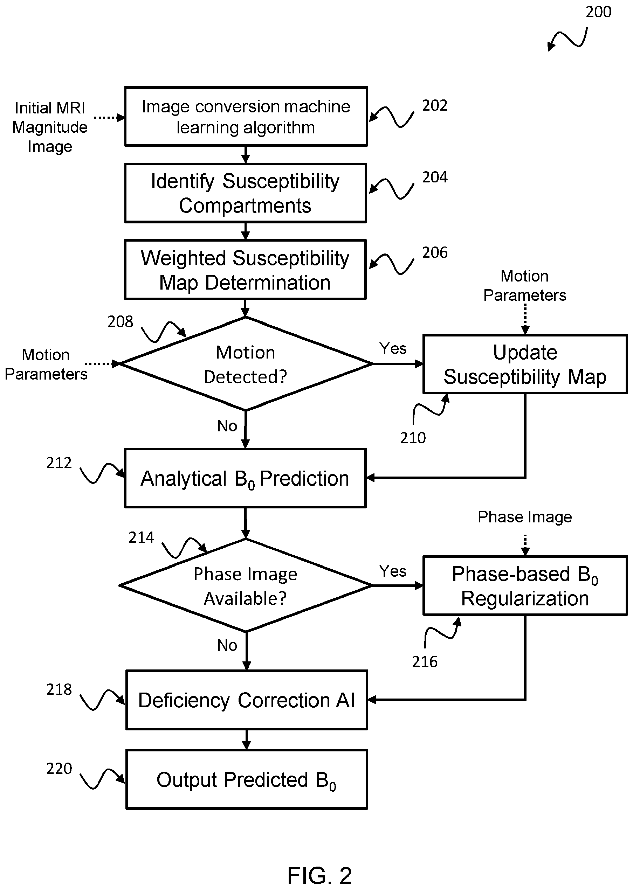

By way of further example, a flow diagram of an exemplary embodiment of a method 200 for predicting a field perturbation map for MRI of a subject, including motion detection, phase-based regularization, and deficiency correction is depicted in Fig. 2.

In step 202, the initial MRI magnitude image is obtained and is input to the image conversion machine learning algorithm. As described above, the image conversion machine learning algorithm takes the initial MRI magnitude image as an input at the start of the scan to generate a synthetic CT image of the subject, the image conversion machine learning algorithm being trained on a large number of MRI-CT pairs.

In step 204, the synthetic CT image and the initial MRI magnitude image may be used for accurate segmentation of the major susceptibility compartments of the subject, and for refining the boundaries between various interfaces of the subject.

In step 206, a weighted susceptibility map is determined from the synthetic CT image and the initial MRI magnitude image. Instead of assigning pre-defined set of susceptibility values to the identified compartments, weighting the susceptibility map based on the identified susceptibility compartments of the subject may account for the partial volume effect across interface boundaries.

In step 208, movement of the subject is determined based on motion parameters. The motion parameters may be received from a motion detection and estimation unit which monitors the subject in the bore of the MRI machine. If the motion parameters indicate that the subject has moved above a threshold minimum movement, then it may be determined that motion has been detected.

Responsive to determining that the subject has moved, the method 200 proceeds to step 210. The subject may be continually monitored before and during the active scanning session, and so this step may occur at any time before or during the active scanning session. In step 210 the weighted susceptibility map is updated based on the movement of the subject. Updating the weighted susceptibility map may comprise updating the orientation of the weighted susceptibility map based on the movement of the subject. As a result, the already generated weighted susceptibility map may be updated and altered, without the need to determine the weighted susceptibility map from an updated synthetic CT image and initial MRI magnitude image of the subject.

In other words, the weighted susceptibility map is generated from the initial MRI magnitude image, and this may only be generated once. If the system detects any motion during active scanning sessions, the already generated weighted susceptibility map may be updated using the motion parameters it receives from a motion detection and estimation unit.

Responsive to determining that the subject has not moved, or upon updating the weighted susceptibility map, the method 200 proceeds to step 212. In step 212, the field perturbation map of the subject is determined from the weighted susceptibility map, or the updated weighted susceptibility map as the case may be. The field perturbation map may be obtained from the weighted susceptibility map using an analytical method.

In step 214, it may be determined whether a phase of the initial MRI magnitude image is available. This may be dependent on the scan type used to obtain the MRI magnitude image, or may be dependent on the MRI machine itself. The survey scan may be a gradient echo scan, or an asymmetric spin echo scan.

Responsive to determining that the phase of the initial MRI magnitude is available, the method 200 proceeds to step 216. In step 216, the field perturbation map may be regularized at the interfaces. This regularization is performed based on the phase of the initial MRI magnitude image. As a result of this regularization, a field perturbation map of higher quality may be obtained.

Responsive to determining that the phase of the initial MRI magnitude is not available, or upon regularizing the field perturbation map, the method 200 proceeds to step 218. In step 218, deficiencies of the field perturbation map may be corrected. These deficiencies may be due to the inherent limitations of the analytical approach of determining the field perturbation map based on the weighted susceptibility map, as the analytical approach may be unable to generalize well. For correcting these deficiencies, an image regeneration machine learning algorithm may be used. The image regeneration machine learning algorithm may process the field perturbation map for further refinement. As a result, the field perturbation map may be more accurate, and may be used for more accurate reconstructed images.

In step 220, the predicted field perturbation map may be output. The predicted field perturbation map may subsequently be used to set appropriate shim currents of the MRI machine, or to reconstruct the MRI scans. In this way, artifacts in the MRI image of the subject may be suppressed, and an image of higher quality may be obtained.

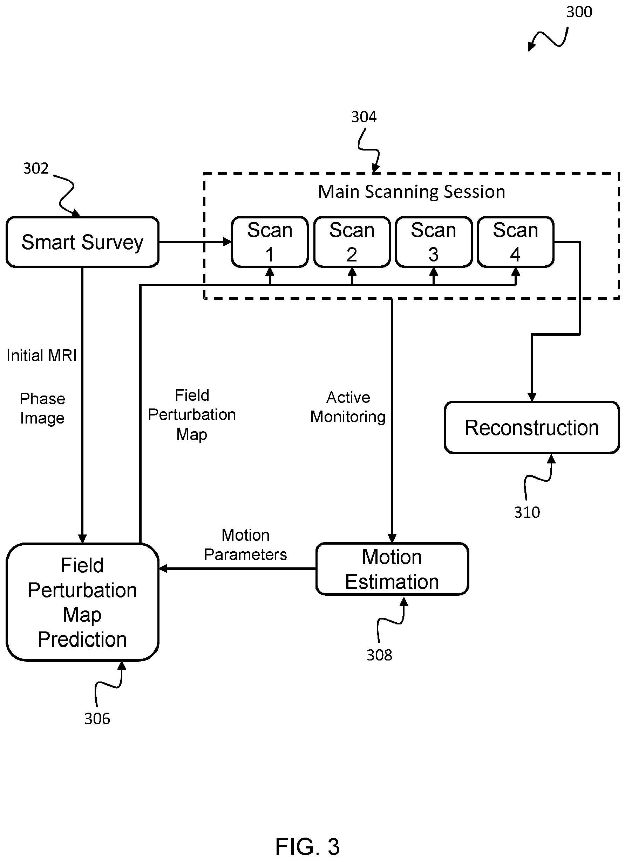

By way of further example, Fig. 3 illustrates a simplified block diagram of a system 300 in which a predicted field perturbation map of a subject may be used prospectively.

A field perturbation map prediction module 306 may predict the field perturbation map directly from the survey scan 302. The survey scan 302 includes the initial MRI magnitude image, and may include the phase image if available (depending upon the scan type). Throughout the main scanning session 304, the subject in the bore may be monitored for movement by a motion estimation unit 308. If there is a motion detected, the motion parameters may be fed back to the field perturbation map prediction module 306 in order to reconstruct the field perturbation map for the latest orientation of the subject.

In other words, before the main scanning session 304, a smart survey scan 302 may be performed on the subject in the bore of the MRI machine. This includes information such as an initial MRI magnitude image, and may further include a phase image. This information is used in order to produce a field perturbation map of the subject in the bore, which may be fed back into the main scanning session 304. If a phase image has also been acquired, this may be used to regularize the field perturbation map of the subject. The field perturbation map may be used by the main scanning session 304, for example, to change the shim current input to the shim coil of the MRI machine. As a result, an image contained in the reconstruction stage from the MRI may contain fewer artifacts, and thus be of higher quality. Due to the fact that the initial MRI image is used to produce the field perturbation map, it is not necessary to perform additional scans in order to directly obtain the field perturbation map.

Throughout the main scanning session 304, the subject may be actively monitored in the bore by a motion estimation unit 308 to determine whether movement has occurred. If movement has occurred, then this may change the magnetic field inhomogeneities within the bore, and therefore an update weighted susceptibility map will be required to obtain an accurate field perturbation map. Therefore, measured motion parameters may be used to update the field perturbation map, which then map be used for the main scanning session 304. If the field perturbation map has changed at various times during the main scanning session 304, then this may be recorded and also used retrospectively in the reconstruction stage to remove artifacts present in the scan image, and improve image quality.

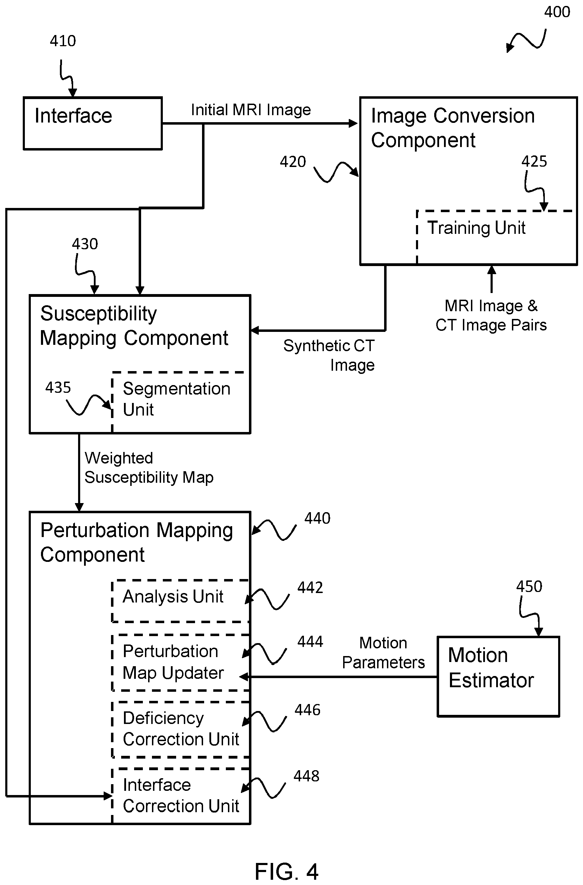

Fig. 4 depicts a block diagram of an exemplary embodiment of a system 400 for predicting a field perturbation map of a subject.

An interface 410 is provided which is configured to obtain an initial MRI magnitude image of the subject. This may be obtained from an initial survey scan. In some embodiments, the initial MRI magnitude image may also contain a phase image.

Further, an image conversion component 420 is provided which receives the initial MRI magnitude image, and generates a synthetic CT image based on the initial MRI magnitude image from the interface 410. The image conversion component 420 generates the synthetic CT image by inputting the initial MRI image to an image conversion machine learning algorithm. The image conversion component 420 may include a training unit 425 configured to train the image conversion machine learning algorithm trained using a training algorithm configured to receive an array of training inputs and known outputs. The training inputs may be MRI images and the known outputs may be CT images, with the MRI images and CT images are provided in pairs which each correspond to the same subject.

In addition, a susceptibility mapping component 430 is provided, which is configured to determine a weighted susceptibility map based on the synthetic CT image from the image conversion component 420, and the initial MRI magnitude image. In some embodiments, the susceptibility mapping component 430 may include a segmentation unit 435 configured to identify susceptibility compartments of the subject based on the initial MRI magnitude image and the synthetic CT image. In other words, the segmentation unit 435 segments regions of the subject, which may be at interface boundaries between different tissue types or major geometries. The susceptibility mapping component 430 may then be further configured to determine the weighted susceptibility map based on the identified susceptibility compartments in order to account for a partial volume effect across boundaries.

A perturbation mapping component 440 is also provided, which is configured to determine the field perturbation map of the subject based on the weighted susceptibility map provided by the susceptibility mapping component 430. In an exemplary embodiment, the perturbation mapping component 440 may further include an analysis unit 442 configured to determine the field perturbation map based on an analytical method.

In some embodiments, the perturbation mapping component 440 may include a deficiency correction unit 446. The deficiency correction unit 446 may correct deficiencies of the field perturbation map by using an image regeneration machine learning algorithm. In this way, known limitations of analytical methods of determining field perturbation maps from susceptibility maps may be overcome, particularly where the known limitations include a lack of ability to generalize well.

In further exemplary embodiments, the perturbation mapping component 440 may also include an interface correction unit 448 configured to regularize the field perturbation map at interfaces based on a phase of the initial MRI magnitude image. The phase of the initial MRI magnitude image may be supplied by the interface 410. This regularization may improve the quality of the perturbation map at interface boundaries.

The system may also include a motion estimator 450. The motion estimator 450 may be configured to determine movement of the subject in the bore of an MRI machine during a scanning session. The motion estimator 450 may be configured to provide detected motion parameters to the perturbation mapping component 440. The perturbation mapping component may also include perturbation map updater 444 configured to update the weighted susceptibility map received from the susceptibility mapping component 430 in response to receiving motion parameters. This update may comprise updating the orientation of the weighted susceptibility map based on the motion parameters. The perturbation map updater 444 may then update the field perturbation map of the subject based on the updated weighted susceptibility map. When a motion estimator 450 and a perturbation map updater 444 are provided, then movements of the subject occurring after the initial MRI magnitude image may be obtained and accounted for, leading to improved image quality throughout the scanning session.

The present invention may be a method, a system, and/or a computer program product. The computer program product may include a computer readable storage medium (or media) having computer readable program instructions thereon for causing a processor to carry out aspects of the present invention.

The computer readable storage medium can be a tangible device that can retain and store instructions for use by an instruction execution device. The computer readable storage medium may be, for example, but is not limited to, an electronic storage device, a magnetic storage device, an optical storage device, an electromagnetic storage device, a semiconductor storage device, or any suitable combination of the foregoing.

Aspects of the present invention are described herein with reference to flowchart illustrations and/or block diagrams of methods, apparatus (systems), and computer program products according to embodiments of the invention. It will be understood that each block of the flowchart illustrations and/or block diagrams, and combinations of blocks in the flowchart illustrations and/or block diagrams, can be implemented by computer readable program instructions.

A single processor or other unit may fulfill the functions of several items recited in the claims.

It will be understood that the disclosed methods are computer-implemented methods. As such, there is also proposed a concept of a computer program comprising code means for implementing any described method when said program is run on a processing system.

The skilled person would be readily capable of developing a processor for carrying out any herein described method. Thus, each step of a flow chart may represent a different action performed by a processor, and may be performed by a respective module of the processing processor.

As discussed above, the system makes use of a processor to perform the data processing. The processor can be implemented in numerous ways, with software and/or hardware, to perform the various functions required. The processor typically employs one or more microprocessors that may be programmed using software (e.g. microcode) to perform the required functions. The processor may be implemented as a combination of dedicated hardware to perform some functions and one or more programmed microprocessors and associated circuitry to perform other functions.

Examples of circuitry that may be employed in various embodiments of the present disclosure include, but are not limited to, conventional microprocessors, application specific integrated circuits (ASICs), and field-programmable gate arrays (FPGAs).

In various implementations, the processor may be associated with one or more storage media such as volatile and non-volatile computer memory such as RAM, PROM, EPROM, and EEPROM. The storage media may be encoded with one or more programs that, when executed on one or more processors and/or controllers, perform the required functions. Various storage media may be fixed within a processor or controller or may be transportable, such that the one or more programs stored thereon can be loaded into a processor.

Variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality. A single processor or other unit may fulfill the functions of several items recited in the claims. The mere fact that certain measures are recited in mutually different dependent claims does not indicate that a combination of these measures cannot be used to advantage. A computer program may be stored/distributed on a suitable medium, such as an optical storage medium or a solid-state medium supplied together with or as part of other hardware, but may also be distributed in other forms, such as via the Internet or other wired or wireless telecommunication systems. If the term "adapted to" is used in the claims or description, it is noted that the term "adapted to" is intended to be equivalent to the term "configured to". Any reference signs in the claims should not be construed as limiting the scope.

## Claims

1. A method (100) of predicting a field perturbation map for magnetic resonance imaging, MRI, of a subject, comprising:
obtaining (102) an initial MRI magnitude image of the subject;
generating (104) a synthetic computed tomography, CT, image based on the initial MRI magnitude image by using an image conversion machine learning algorithm;
determining (106) a weighted susceptibility map based on the synthetic CT image and the initial MRI magnitude image; and
determining (108) a field perturbation map for the subject based on the weighted susceptibility map.

2. The method of claim 1, wherein the image conversion machine learning algorithm is trained using a training algorithm configured to receive an array of training inputs and known outputs, wherein the training inputs comprise MRI images and the known outputs comprise CT images, and wherein the MRI images and CT images are provided in pairs.

3. The method of any preceding claim, wherein determining the field perturbation map is further based on an analytical method.

4. The method of any preceding claim, further comprising:
identifying (204) susceptibility compartments of the subject based on the initial MRI magnitude image and the synthetic CT image, and
wherein determining (206) the weighted susceptibility map is based on the identified susceptibility compartments to account for a partial volume effect across boundaries.

5. The method of any preceding claim, further comprising regularizing the field perturbation map (216) at interfaces based on a phase of the initial MRI magnitude image.

6. The method of any preceding claim, further comprising correcting deficiencies of the field perturbation map (218) by using an image regeneration machine learning algorithm.

7. The method of any preceding claim, further comprising:
determining movement (208) of the subject;
updating the weighted susceptibility map (210) based on the movement of the subject; and
updating the field perturbation map (212) based on the updated weighted susceptibility map.

8. The method of claim 7, wherein updating the weighted susceptibility map (212) comprises updating the orientation of the weighted susceptibility map based on the movement of the subject.

9. A computer program comprising code means for implementing the method of any preceding claim when said program is run on a processing system.

10. A system (400) for predicting a field perturbation map for magnetic resonance imaging, MRI, of a subject, comprising:
an interface (410) configured to obtain an initial MRI magnitude image of the subj ect;
an image conversion component (420) configured to generate a synthetic computed tomography, CT, image based on the initial MRI magnitude image by using an image conversion machine learning algorithm;
a susceptibility mapping component (430) configured to determine a weighted susceptibility map based on the synthetic CT image and the initial MRI magnitude image; and
a perturbation mapping component (440) configured to determine the field perturbation map of the subject based on the weighted susceptibility map.

11. The system of claim 10, wherein the image conversion component (420) comprises a training unit (425) configured to train the image conversion machine learning algorithm trained using a training algorithm configured to receive an array of training inputs and known outputs, wherein the training inputs comprise MRI images and the known outputs comprise CT images, and wherein the MRI images and CT images are provided in pairs.

12. The system of claim 10 or 11, wherein the perturbation mapping component (440) comprises an analysis unit (442) configured to determine the field perturbation map based on an analytical method.

13. The system of any of claims 10 to 12, wherein the susceptibility mapping component (430) comprises a segmentation unit (435) configured to identify susceptibility compartments of the subject based on the initial MRI magnitude image and the synthetic CT image, and
wherein the susceptibility mapping component is further configured to determine the weighted susceptibility map based on the identified susceptibility compartments in order to account for a partial volume effect across boundaries.

14. The system of any of claims 10 to 13, wherein the perturbation mapping component (440) further comprises an interface correction unit (448) configured to regularize the field perturbation map at interfaces based on a phase of the initial MRI magnitude image.

15. The system of any of claims 10 to 14, wherein the perturbation mapping component (440) further comprises a deficiency correction unit (446) configured to correct deficiencies of the field perturbation map by using an image regeneration machine learning algorithm.
